# EUROPÄISCHE PATENTSCHRIFT

(11) **EP 2 702 594 B1**
(45) Veröffentlichungstag und Bekanntmachung des Hinweises auf die Patenterteilung: **03.02.2016**
(21) Anmeldenummer: 12716052.1
(22) Anmeldetag: 24.04.2012
(51) Int. Cl.: C23C 14/00, C23C 14/02, C23C 14/16, G21G 1/00, H01J 37/34

(54) **VERFAHREN ZUR HERSTELLUNG VON AUSGANGSMATERIAL FÜR EINEN TECHNETIUM-GENERATOR**
METHOD FOR PRODUCING STARTING MATERIAL FOR A TECHNETIUM GENERATOR
PROCÉDÉ DE PRÉPARATION DE MATÉRIAU DE DÉPART POUR UN GÉNÉRATEUR À TECHNÉTIUM

(30) Priorität: 26.04.2011 DE 102011002265
(43) Veröffentlichungstag der Anmeldung: 05.03.2014
(73) Patentinhaber: Technische Universität München, 80333 München (DE)
(72) Erfinder: SCHMID, Wolfgang, 83734 Hausham (DE); PETRY, Winfried, 85598 Baldham (DE)
(74) Vertreter: Herrmann, Franz
(86) Internationale Anmeldenummer: PCT/EP2012/057494
(87) Internationale Veröffentlichungsnummer: WO 2012/146586

(56) Entgegenhaltungen:
- CN-A- 101 866 701
- GB-A- 1 369 700
- US-A- 3 799 883
- US-A- 6 160 862

## Beschreibung

Die Erfindung betrifft ein Verfahren zur Herstellung von Ausgangsmaterial für einen Technetium-Generator mit den Verfahrensschritten:
- Bereitstellen eines Substrats, und
- Ausbilden einer Ausgangsschicht auf dem Substrat durch Aufsputtern von uranhaltigem Ausgangsmaterial aus der Gasphase auf das Substrat.

Die Erfindung betrifft ferner ein Verfahren zur Herstellung eines Technetium-Generators und ein Ausgangsmaterial zur Herstellung eines Technetium-Generators.

Aus der DE 2 164 268 A ist ein Verfahren bekannt, bei dem uranhaltiges Ausgangsmaterial mithilfe eines galvanischen Verfahrens auf die Innenseite eines zylindrischen Behälters aufgebracht wird. Das so geschaffene Ausgangsmaterial kann dann mit Neutronen bestrahlt und nach Abschluss der Bestrahlung einer Verarbeitungsstätte für die Abtrennung und Verarbeitung der Spaltprodukte zugeführt werden, in der das bestrahlte Ausgangsmaterial mithilfe eines Lösungsmaterials von der Innenseite des Behälters gelöst werden kann.

Das bestrahlte Ausgangsmaterial enthält insbesondere ⁹⁹Mo, das mit einer Halbwertszeit von 66 Stunden zu ^{99m}Tc zerfällt. ^{99m}Tc wird in der nuklearen Medizin häufig als Marker verwendet, weist aber eine für den Transport sehr ungünstige Halbwertszeit von nur 6 Stunden auf. Der Behälter mit dem bestrahlten Ausgangsmaterial wird daher als sogenannter Technetium-Generator verwendet, aus dem das sich bildende ^{99m}Tc wiederholt ausgelöst werden kann.

Ein Nachteil des bekannten Verfahrens zur Herstellung von Ausgangsmaterial für einen Technetium-Generator ist, dass sich die Zusammensetzung der auf der Innenseite des Behälters ausgebildeten Ausgangsschicht nur schwer kontrollieren lässt. Falls nicht für jeden Beschichtungsvorgang eine uranhaltige Lösung neu hergestellt wird, kann die Lösung über die Zeit hinweg verunreinigt werden, was zu unerwünschten Effekten führen kann. Die Lösung für jeden Beschichtungsvorgang neu anzusetzen, hat jedoch eine große Abfallmenge zur Folge.

In der DE 2 164 268 A wird daneben auch die Möglichkeit erwähnt, das uranhaltige Ausgangsmaterial auf der Innenseite des Behälters nach bekannten Arbeitsweisen durch Zerstäuben, Ionplattieren oder Verdampfen aufzubringen. Einzelheiten zu diesen Verfahren werden jedoch nicht erwähnt.

Auch as der US 37 99 833 A und der GB 1369 700 A ist bekannt, die Ausgangschicht durch Aufstäuben auszubilden.

Aus der WO 2007/059851 A1 ist ferner ein Verfahren zum Herstellen eines Brennelements für einen Kernreaktor bekannt, bei dem spaltbares Material aus der Gasphase auf einem Hüllmaterial abgeschieden wird. Insbesondere wird vorgeschlagen, eine U-Mo-Legierung bei einer Temperatur zwischen 600°C bis 1300°C aufzustäuben.

THORNTON, J. A.: High Rate Thick Film Growth, Annual Review of Materials Science, 1977.7, Seite 239-260, enthält grundsätzliche Ausführungen zur Herstellung dicker Schichten und beschreibt die so genannten Thornton-Diagramme.

In der Veröffentlichung KLUTH, O. et al: "Modified Thornton model for magnetron sputtered zinc oxide: film structure and etching behaviour" in Thin Solid Films, Vol. 442, No. 1-2, Seite 80 - 85 wird von möglichen Verfahren für die Ausbildung von ZnO-Schichten berichtet, die insbesondere für die Ausbildung von transparenten leitfähigen Oxidschichten auf Dünnschicht-Solarzellen von Interesse sind. Gemäß dieser Veröffentlichung ist insbesondere der Prozessdruck während des Zerstäubungsvorgangs für die Ätzeigenschaften der aufgestäubten Zinkoxidschicht entscheidend.

Ausgehend von diesem Stand der Technik liegt der Erfindung daher die Aufgabe zugrunde, ein verbessertes Verfahren zur Herstellung von Ausgangsmaterial für einen Technetium-Generator zu schaffen.

Diese Aufgabe wird durch ein Verfahren mit den Merkmalen des unabhängigen Anspruchs gelöst. In davon abhängigen Ansprüchen sind vorteilhafte Ausgestaltungen und Weiterbildungen angegeben.

Bei dem Verfahren wird das Ausgangsmaterial durch Zerstäuben (= Sputtern) in die Gasphase gebracht und die Ausgangsschicht mit einer Schichtstruktur gemäß Zone I oder Zone T des Thorntondiagramms des zugehörigen Ausgangsmaterials auf das Substrat aufgesputtert. Es hat sich gezeigt, dass das derart aufgebrachte uranhaltige Ausgangsmaterial nach dem Bestrahlen mit Neutronen sich gut vom Substrat entfernen und zur Separation von ^{99m}Tc auflösen lässt, da die aufgelockerte Ausgangsschicht einem Lösungsmittel eine große Angriffsfläche bietet.

Eine derartige Ausgangsschicht kann gebildet werden, wenn das Substrat während des Aufbringens eine in Kelvin gemessene Temperatur T annimmt, für die T [K]/Tₛ [K] < 0,4 gilt, wobei Tₛ die in Kelvin gemessene Schmelztemperatur des Ausgangsmaterials ist.

Die Lockerheit der uranhaltigen Ausgangsschicht nimmt noch zu, wenn das Substrat während des Aufbringens eine in Kelvin gemessene Temperatur T annimmt, für die T [K]/Tₛ [K] < 0,2 gilt, wobei Tₛ die in Kelvin gemessene Schmelztemperatur des Ausgangsmaterials ist.

Darüber hinaus kann es von Vorteil sein, wenn das Substrat auf eine Temperatur unterhalb der Umgebungstemperatur gekühlt wird, um auf diese Weise eine aufgelockerte und leicht lösbare Ausgangsschicht zu erhalten.

Zum Aufstäuben wird insbesondere ein Material auf der Basis von Uran oder Uranmolybdän als Ausgangsmaterial verwendet.

Das Ausgangsmaterial kann mit Hilfe einer Magnetron-Zerstäubungsanlage aufgebracht werden, die eine Sputterelektrode und einer Substratelektrode aufweist, zwischen denen ein elektrisches Feld vorhanden ist, und die ferner über eine Magnetanordnung verfügt, die ein magnetisches Feld im Bereich der Sputterelektrode erzeugt.

Bei einem zylinderförmigen Substrat kann das Ausgangsmaterial insbesondere in einer Magnetron-Zerstäubungsanlage aufgebracht werden, bei der die Sputterelektrode und die Substratelektrode zylinderförmig ausgebildet sind, bei der sich die Sputterelektrode im Inneren der Substratelektrode befindet, und bei der die Magnetanordnung einen im Inneren der Sputterelektrode angeordneten Magneten umfasst, dessen Magnetisierungsrichtung sich entlang der Längsachse der Sputterelektrode erstreckt.

In der Regel muss der Arbeitsdruck in dem Raum oberhalb der Substratoberfläche während des Aufbringens in einem Bereich zwischen 5·10⁻⁴ mbar und 5·10⁻² mbar gehalten werden.

Um die Ausbildung einer Ausgangsschicht mit der Schichtstruktur der Zone I zu fördern, kann der Druck während des Aufbringens von einem Druckbereich, in dem gemäß Thornton-Diagramm eine Ausgangsschicht mit der Schichtstruktur der Zone I gebildet wird, zu einem Arbeitsdruck abgesenkt werden, in dem gemäß Thornton-Diagramm eine Ausgangschicht mit der Schichtstruktur der Zone T gebildet wird, da dann die an der Oberfläche des Substrats adsorbierten Atome zahlreiche kleine Cluster gemäß der Schichtstruktur der Zone I bilden, die Wachstumszentren für den nachfolgenden Schichtaufbau darstellen, der dann überwiegend mit der Schichtstruktur gemäß Zone I erfolgt, obwohl die Prozessparameter auf die Ausbildung einer Schichtstruktur gemäß Zone T eingestellt sind. Auf diese Weise ist es möglich, für einen Großteil der Zeitdauer des Aufbringens einen für die Gasentladung in der Magnetron-Zerstäubungsanlage günstigen, niedrigen Druckbereich zu wählen. Außerdem kann auf eine Kühlung des Substrates verzichtet werden, da der Prozess bei höheren Temperaturen geführt werden kann.

So kann der Arbeitsdruck beim Aufstäuben zu Beginn des Aufbringens im Bereich von 5·10⁻³ mbar bis 5·10⁻² mbar gehalten werden und danach auf den Arbeitsdruck abgesenkt werden.

Neben einer Magnetron-Zerstäubungsanlage kann auch eine Zerstäubungsanlage ohne Magnetanordnung verwendet werden, bei der im Vergleich zu einer Magnetron-Zerstäubungsanlage bei einem höheren Arbeitsdruck eine Gasentladung auftritt. In diesem Fall kann der Arbeitsdruck während des Aufbringens in einem Bereich oberhalb 5·10⁻³ mbar gehalten werden, so dass auf jeden Fall eine Ausgangschicht mit der Schichtstruktur der Zone I erzeugt wird. Allerdings ist der Erosionsprozess in diesem Fall nicht lokal auf die Ausdehnung des Magnetfeldes beschränkt und geht auch langsamer vor sich als bei der Verwendung einer Magnetron-Zerstäubungsanlage.

Um die Substratoberfläche von Verunreinigungen zu reinigen, die die Haftung des aufgestäubten Materials möglicherweise verschlechtern, kann die Oberfläche des Substrats vor Beginn des Aufbringens einer Reinigung durch eine Glimmentladung unterzogen werden. Hierdurch kann eine exzellente Haftung erreicht werden.

Ist es andererseits das Ziel, die aufgestäubte Schicht nach der Bestrahlung komplett zu entnehmen, so wird das Ablösen des Ausgangsmaterials vom Substrat wesentlich erleichtert, wenn die Oberfläche des Substrats vor Beginn des Aufbringens des Ausgangsmaterials mit einer Oxidschicht versehen wird.

Weitere Vorteile und Eigenschaften der Erfindung gehen aus der nachfolgenden Beschreibung hervor, in der Ausführungsbeispiele der Erfindung anhand der Zeichnung im Einzelnen erläutert werden. Es zeigen:
- Figur 1: einen Querschnitt durch eine Sputteranlage;
- Figur 2: einen Querschnitt durch eine rotationssymmetrische Sputteranlage zum Beschichten der Innenwände eines zylinderförmigen Substrats;
- Figur 3: ein typisches Thornton-Diagramm;
- Figur 4: eine schematische Darstellung des Aufbaus aufgesputterter Schichten in Abhängigkeit von der Substrattemperatur T; und
- Figur 5: ein Diagramm, das den zeitlichen Druckverlauf in einer Sputteranlage während des Sputtervorgangs zeigt

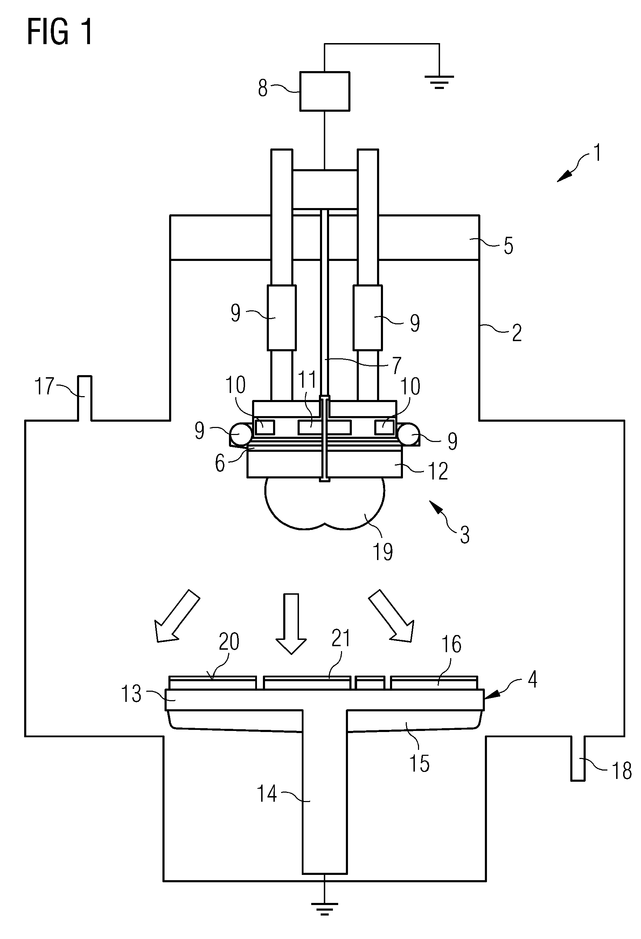

Figur 1 zeigt eine Sputteranlage 1. Die Sputteranlage 1 verfügt über einen Vakuumbehälter 2, in dem ein Sputterkopf 3 und ein Substrathalter 4 eingebracht ist. Der Sputterkopf 3 ist insbesondere an einem Deckel 5 des Vakuumbehälters 2 angebracht und verfügt über eine Sputterelektrode 6, die mittels einer Zuleitung 7 aus einer Hochspannungsquelle 8 mit Spannung versorgt wird. Zu der Sputterelektrode 6 führen ferner Kühlleitungen 9, über die der Sputterkopf 3 gekühlt wird.

Auf einer dem Substrathalter 4 zugewandten Seite sind äußere Dauermagnete 10 und innere Dauermagnete 11 an dem Sputterkopf 3 angebracht. Die Magnetisierung der äußeren Dauermagnete 10 und der inneren Dauermagnete 11 weist bezüglich der Vertikalen in entgegengesetzte Richtungen.

Die Dauermagnete 10 und 11 befinden sich über der Sputterelektrode 6 und insbesondere über dem Sputtermaterialblock 12. Die Distanz zwischen den Dauermagneten 10 und der plasmaseitigen Oberfläche des Sputtermaterialblocks 12 ist jedoch so gering zu wählen, dass eine hinreichende magnetische Flussdichte (> 5 mTesla) an der Oberfläche des Sputtermaterialblocks 12 gewährleistet werden kann.

Der Substrathalter 4 verfügt über eine zum Sputterkopf 3 hin flache Substratelektrode 13, die von einem Elektrodenhalter 14 gehalten ist und auf Massepotential gelegt ist. Der Substrathalter 4 kann ferner mit einer Temperiervorrichtung 15 versehen sein, mit der sich die Temperatur eines auf die Oberseite des Substrathalters 4 aufgebrachten Substrats 16 einstellen lässt. Bei der Temperiervorrichtung 15 kann es sich um eine Heizvorrichtung oder eine Kühlvorrichtung oder eine Kombination von beidem handeln.

Der Vakuumbehälter 2 ist ferner mit einem Gaseinlass 17 und einem Pumpenanschluss 18 versehen. Durch den Gaseinlass 17 kann ein Sputtergas in den Vakuumbehälter 2 eingelassen werden. Bei dem Sputtergas handelt es sich üblicherweise um Argon, dem gegebenenfalls noch Reaktivgase wie Sauerstoff oder Stickstoff beigemischt werden.

Unter dem Einfluss des unter der Sputterelektrode 6 erzeugten elektrischen Feldes werden die Sputtergasatome in der Nähe des Sputterkopfs 3 ionisiert. Die freien Ladungsträger und Sputtergas-Ionen werden von dem Magnetfeld, das durch die Dauermagneten 10 und 11 erzeugt wird, in einem Plasmabereich 19 gehalten. Die ionisierten Sputtergasatome können aus dem Sputtermaterialblock 12 Sputtermaterialatome herausschlagen. Dadurch werden Sputtermaterialatome in die Gasphase gebracht. Die sich in der Gasphase befindenden Sputtergasatome können sich schließlich auf einer Substratoberfläche 20 niederschlagen und die Substratoberfläche 20 mit einer Ausgangsmaterialschicht 21 versehen.

Als Material für den Sputtermaterialblock 12 eignet sich insbesondere eine metallische Uranlegierung hoher Dichte, zum Beispiel Uran-Molybdän. Dementsprechend besteht die Ausgangsmaterialschicht 21 aus dieser Uranlegierung. Daneben kann für den Sputtermaterialblock 12 auch reines Uran oder nichtmetallische Uranverbindungen hoher Dichte, zum Beispiel U₃Si₂, verwendet werden. In diesem Fall besteht die Ausgangsmaterialschicht 21 entweder aus reinem Uran oder ist entsprechend der Zusammensetzung des Sputtermaterialblocks 12 zusammengesetzt.

Es sei angemerkt, dass die Hochspannungsquelle 8 auch eine Hochfrequenzquelle sein kann, wenn das Ausgangsmaterial elektrisch nichtleitend ist. In diesem Fall kann ein sogenanntes Radiofrequenz-Sputtern (= RF-Sputtern) verwendet werden. Wenn elektrisch leitende Ausgangsmaterialien zerstäubt werden sollen, kann ein sogenanntes DC-Sputtern durchgeführt werden und die Hochspannungsquelle hat die Funktion einer Gleichspannungsquelle.

Nach dem Aufbringen der Ausgangsmaterialschicht 21 auf die Substratoberfläche 20 können die Substrate 16 in einem Kernreaktor mit Neutronen bestrahlt werden. Als Spaltprodukt von Uran entsteht dabei ⁹⁹Mo, das zu ^{99m}Tc zerfällt. Die Substrate 16 können daher für einen Technetium-Generator verwendet werden.

Mit der in Figur 1 dargestellten Sputteranlage 1 lassen sich insbesondere flache Substrate 16 beschichten.

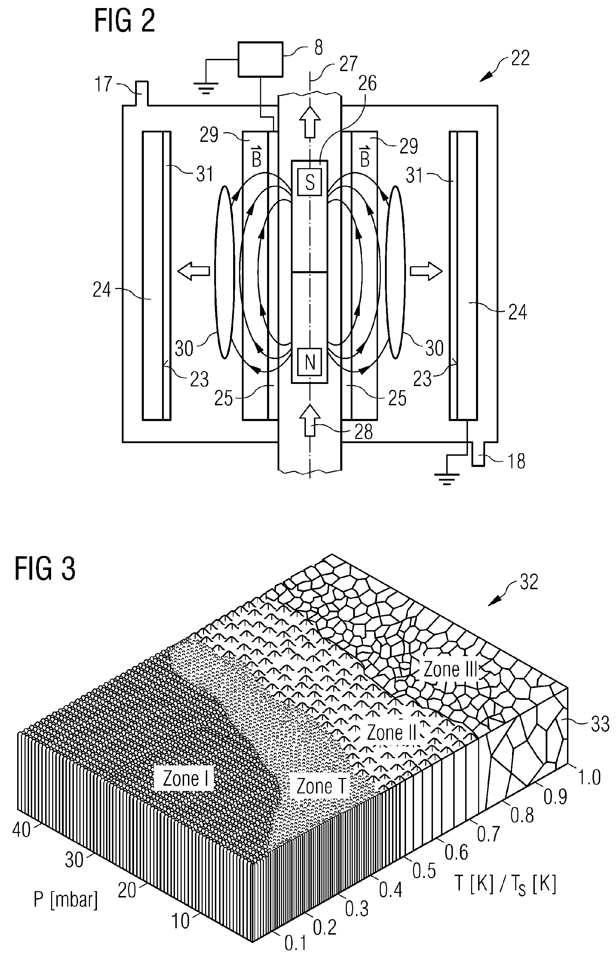

Eine weitere Sputteranlage 22 ist in Figur 2 dargestellt. Die Sputteranlage 22 kann dazu verwendet werden, Innenseiten 23 eines zylinderförmigen Substrats 24 zu beschichten. Zu diesem Zweck ist im Inneren des zylinderförmigen Substrats 24 eine rohrförmige Sputterelektrode 25 angeordnet, die mit der Hochspannungsquelle 8 verbunden ist. Im Inneren der rohrförmigen Sputterelektrode 25 befindet sich ein Stabmagnet 26, dessen Magnetisierung entlang einer Längsachse 27 der rohrförmigen Sputterelektrode 25 verläuft. Die Längsachse 27 der rohrförmigen Sputterelektrode 25 fällt bei der in Figur 2 dargestellten Sputteranlage 22 auch mit der Zylinderachse des zylinderförmigen Substrats 24 zusammen. Durch das Innere der rohrförmigen Sputterelektrode 25 kann auch ein Kühlmittel gepumpt werden, das insbesondere dafür sorgt, dass sich der Stabmagnet 26 und der Sputtermaterialmantel 29 nicht erwärmen.

Bei der in Figur 2 dargestellten Sputteranlage 22 dient das Substrat 24 gleichzeitig auch als Substratelektrode.

Die Strömung der Kühlflüssigkeit ist in Figur 2 durch Pfeile 28 angedeutet.

Die rohrförmige Sputterelektrode 25 ist ferner von einem Sputtermaterialmantel 29 umgeben, der aus dem auf die Innenseite 23 des Substrats 24 aufzusputternden Material besteht.

Beim Sputtern wird der Innenraum des Vakuumbehälters 2 mit dem Sputtergas beaufschlagt, bei dem es sich ebenso wie bei der in Figur 1 dargestellten Sputteranlage 1 in der Regel um Argon handelt, dem gegebenenfalls Reaktivgas beigemischt wurde. Durch Anlegen einer Hochspannung aus der Hochspannungsquelle 8 können die Sputtergasatome ionisiert werden. Die ionisierten Sputtergasatome werden von dem Magnetfeld, das durch den Stabmagneten 26 erzeugt wird, in einer torusförmigen Plasmaregion 30 und damit in der Nähe des Sputtermaterialmantels 29 gehalten. Die von den ionisierten Sputtergasatomen aus dem Sputtermaterialmantel 29 herausgeschlagenen Sputtermaterialatome werden dann in einer Ausgangsschicht 31 auf der Innenseite 23 des zylinderförmigen Substrats 24 abgeschieden. Das zylinderförmige Substrat 24 kann nach dem Beschichten beidseitig verschlossen und mit Neutronen bestrahlt werden. Auf diese Weise lässt sich ein Technetium-Generator herstellen.

Ein wesentlicher Parameter für die Durchführung des Sputterverfahrens ist der Abstand zwischen Sputterziel und Substrat 16 oder 24, der erfahrungsgemäß mindestens 80 mm betragen sollte. Bei dem Sputterziel handelt es sich um den Sputtermaterialblock 12 oder den Sputtermaterialmantel 29. Insbesondere bei einem Abstand von mehr als 100 mm kann das Verfahren in der Regel ohne Beeinträchtigungen durchgeführt werden.

Der Abstand zwischen Sputterziel und Substrat 16 oder 24 muss nicht notwendigerweise auf die Größe des Substrats 16 oder 24 eingestellt werden. Wenn der Abstand groß genug gewählt wird, weisen große Substrate 16 mit einer Abmessung von 700 mm x 122 mm und kleine Substrate 16 mit einer Ausdehnung von 10 mm x 10 mm jeweils aufgelockerte Ausgangsschichten 21 auf, die frei von Ausbrüchen sind. Falls der Abstand jedoch zu klein gewählt wird, tritt ein sogenanntes Flaking auf, unter dem das Ablösen einzelner Schichtbrocken verstanden wird. Eine gute Haftung der aufgesputterten Schichten auf dem Substrat 16 oder 24 kann bei zu kleinem Abstand ebenso wenig gewährleistet werden wie ein guter thermischer Kontakt, was beides für die Anwendung als Bestrahlungstarget notwendig ist.

Weitere wichtige Verfahrensparameter sind Sputtergasdruck und Substrattemperatur während des Sputtervorgangs.

In Figur 3 ist ein Thornton-Diagramm 32 dargestellt, bei dem die Materialstruktur in Abhängigkeit vom Druck gemessen in mbar und von der auf die Schmelztemperatur Tₛ[K] des aufgesputterten Materials bezogene Temperatur T[K] des Substrats aufgetragen ist. Die Schmelztemperatur Tₛ und die Temperatur T des aufgesputterten Materials sind jeweils in Kelvin angegeben.

Es können vier Zonen, nämlich Zone I, Zone T, Zone II und Zone III unterschieden werden. In diesen Zonen weist eine aufgesputterte Schicht 33 jeweils unterschiedliche Schichtstrukturen auf.

Es sei angemerkt, dass Figur 3 die Verteilung der Schichtstruktur lediglich schematisch wiedergibt, da die Verteilung der Schichtstruktur materialabhängig ist. Ferner sei angemerkt, dass die Schmelztemperatur von Uran bei 1406 Kelvin liegt. Die Schmelztemperatur von Uran-Molybdän beginnt bei geringem Molybdän-Gehalt bei 1406 Kelvin und steigt mit zunehmendem Molybdän-Gehalt monoton bis zur Schmelztemperatur von reinem Molybdän auf 2896 Kelvin an.

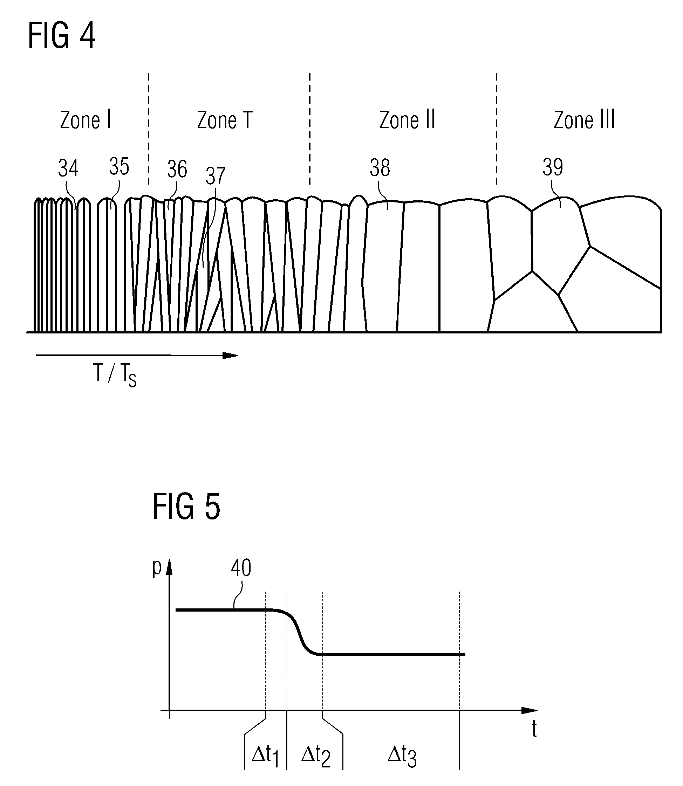

In Figur 4 sind typische Schichtstrukturen der einzelnen Zonen dargestellt. In der Zone I weist die Schichtstruktur säulenartige Körner 34 mit dazwischen liegenden Freiräumen 35 auf. Die Zone T ist durch säulenartige Körner 36 mit dazwischen liegenden Hohlräumen 37 gekennzeichnet. In der Zone II bildet sich eine geschlossene Schicht aus säulenartigen Körnern 38. In der Zone III entstehen schließlich kompakte Körner 39. Die unterschiedliche Schichtstruktur beruht insbesondere auf der bei verschiedenen Temperaturen unterschiedlichen Beweglichkeiten der auf der Substratoberfläche adsorbierten Atome. Je höher die Substrattemperatur ist, desto besser ist auch die Beweglichkeit der adsorbierten Atome. In der Zone I bewirkt die Abschattung durch bereits adsorbierte Atome die Bildung der Freiräume 35. Mit steigender Temperatur des Substrats nimmt auch die Beweglichkeit der Atome in der Schicht 33 zu. Die Atome können sich zunehmend in seitliche Richtung anlagern und die Freiräume 35 und Hohlräume 37 ausfüllen. In der Zone III schließlich, verschieben sich aufgrund von Diffusionsvorgängen die Korngrenzen und es entstehen die kompakten Körner 39.

Es hat sich gezeigt, dass die einzigen unter Bestrahlung stabilen und zudem noch dichtesten Kristallstrukturen des Urans, die γ-Phasen, bereits dann erzeugt werden, wenn das Substrat 16 oder 24 beim Aufsputtern Zimmertemperatur aufweist. Diese Phasen zerfallen jedoch mit der Zeit, sofern sie nicht thermodynamisch stabilisiert werden. Dies geschieht üblicherweise, indem ein stabilisierendes Element, zum Beispiel Molybdän, zum Uran hinzulegiert wird.

Die Gammaphasen entstehen ebenso, wenn die Substrattemperatur sehr hoch ist, nahe der Schmelztemperatur Tₛ. Bei diesen Temperaturen ist jedoch keine Schichtstruktur entsprechend Zone I mehr zu realisieren.

Bezogen auf die Schichtmorphologie bedeutet ein Aufsputtern bei Zimmertemperatur, dass die Schicht 33 mit einer Kornstruktur aufwächst, die der Zone T des Thornton-Diagramms entspricht. Dies sind die säulenartigen Körner 36, die trotz der Zwischenräume 37 eine kompakte Ausgangsschicht 21 oder 31 mit der annähernden Dichte eines Vollmaterials auf dem Substrat 16 oder 24 bilden.

Ein Aufsputtern bei höheren Temperaturen würde zu einer Schichtstruktur analog zur Thornton-Zone II führen. Dazu müsste die Temperatur T[K] des Substrats im Bereich von 0,3 - 0,4 Tₛ des aufzusputternden Materials gehalten werden. Falls die Temperatur T[K] des Substrats im Bereich von 0,5 - 0,6 Tₛ des aufzusputternden Materials gehalten wird, ergibt sich eine Schichtstruktur entsprechend der Zone III. Schichten 33 mit der Schichtstruktur gemäß Zone II oder Zone III sind geringfügig kompakter und daher auch geringfügig dichter als Schichten 33 mit Zone T-Struktur. Insofern wäre es möglich mit Schichten 33, die die Schichtstruktur der Zone II oder der Zone III aufweisen, mehr Technetium zu gewinnen. Der Dichtegewinn liegt allerdings im Promillebereich. Der nötige apparatetechnische Aufwand zur Heizung des Substrats 16 oder 24 scheint in Anbetracht dieses geringen Dichtegewinns nicht gerechtfertigt zu sein, zumal dadurch die Lösbarkeit deutlich verschlechtert wird.

Durch eine Kühlung des Substrats 16 oder 24 während der Deposition besteht ferner die Möglichkeit, eine uranhaltige Ausgangsschicht 21 oder 31 in der Thornton-Zone I zu erzeugen. Diese ist charakterisiert durch eine Kornstruktur bestehend aus einzelnen säulenartigen Körnern 34 mit größeren Freiräumen 35 zwischen den säulenartigen Körnern 34. Die Schichtstruktur der Zone I wird insbesondere durch Aufsputtern mit einer Substrattemperatur < 0,15 Tₛ erzeugt. Sofern dies bei den Bestrahlungstargets erwünscht ist, kann durch die Struktur der Zone I eine aufgelockerte und mit Freiräumen durchsetzte Ausgangsschicht 21 oder 31 erzeugt werden, die mehr Oberfläche und daher mehr Angriffsfläche für ein Lösungsmittel bietet als eine vollständig kompakte Ausgangsschicht 21 oder 31. Dies vereinfacht und beschleunigt den Prozessschritt des Auflösens der bestrahlten Ausgangsschicht 21 oder 31 in Säure.

Der Druck der zum Sputtern nötigen Gasentladung kann beim Einsatz der Dauermagnete 10 und 11 sowie des Stabmagnets 26 im Bereich von 5·10⁻⁴ mbar bis 5·10⁻² mbar gehalten werden, wobei der genaue Druckbereich vom verwendeten Ausgangsmaterial abhängt. Wird der Druck höher, so destabilisiert sich die magnetisch eingeschlossene Glimmentladung und geht in eine normale Glimmentladung über.

Es ist auch vorteilhaft, wenn der Druck möglichst niedrig ist, da dann die Streuung der Atome an die Wände der Sputteranlage 1 oder 22 gering gehalten werden kann.

Allerdings muss der Sputtergasdruck hoch genug sein, um gemäß Thornton-Diagramm die gewünschte Schichtmorphologie zu erreichen. Anhand des Thornton-Diagramms 32 ist erkennbar, dass die Ausbildung einer Ausgangsschicht 21 oder 31 mit der Schichtstruktur gemäß Zone I bei niedrigem Druck auch eine niedrige Temperatur erfordert, die auch unterhalb der Raumtemperatur von 293 Kelvin liegen kann. Das Substrat 16 oder 24 müsste dann gekühlt werden.

Es hat sich gezeigt, dass es von Vorteil ist, wenn zu Beginn des Sputtervorgangs der Druck für einige Minuten im Bereich von 8·10⁻³ mbar gehalten wird, da dann die an der Oberfläche des Substrats 16 oder 24 absorbierten Atome zahlreiche kleine Cluster bilden, die Wachstumszentren für den nachfolgenden Schichtaufbau darstellen.

In Figur 5 ist der typische Druckverlauf während eines derartigen Sputtervorgangs dargestellt. Eine Druckkurve 40 gibt dabei den ungefähren Verlauf des Drucks während des Sputtervorgangs wieder. Zu Beginn, während eines Zeitraums Δt₁, wird der Druck in einem Bereich von 8 · 10⁻³ mbar gehalten. Während eines weiteren Zeitintervalls Δt₂ wird der Druck auf einen Wert im Bereich zwischen 1 · 10⁻³ und 3 · 10⁻³ mbar abgesenkt und während einer Zeitspanne Δt₃ beibehalten. Die Länge des Zeitraums Δt₁ beträgt in der Regel einige Minuten.

Durch eine derartige Druckabsenkung wird die Ausgangsschicht 21 oder 31 mit der Schichtstruktur der Zone I ausgebildet, da dann die an der Substratoberfläche 20 oder der Innenseite 23 adsorbierten Atome zahlreiche kleine Cluster gemäß der Schichtstruktur der Zone I bilden, die Wachstumszentren für den nachfolgenden Schichtaufbau darstellen, der dann überwiegend mit der Schichtstruktur gemäß Zone I erfolgt, obwohl die Prozessparameter auf die Ausbildung einer Schichtstruktur gemäß Zone T eingestellt sind. Auf diese Weise ist es möglich, für einen Großteil der Zeitdauer des Aufbringens einen für die Gasentladung in der Sputteranlage 1 oder 22 günstigen, niedrigen Druckbereich zu wählen. Außerdem kann auf eine Kühlung des Substrats 16 oder 24 verzichtet werden.

Das von den Dauermagneten 10 und 11 oder dem Stabmagnet 26 erzeugte permanente Magnetfeld kann mit Hilfe von Neodym-Eisen-Bor-Magneten hergestellt werden, die eine Remanenz bis zu 1,4 Tesla aufweisen.

Falls die Dauermagnete 10 und 11 oder der Stabmagnet 26 weggelassen werden, muss der Druck oberhalb von 5·10⁻² mbar, insbesondere in dem Bereich von 10⁻² mbar bis 100 mbar liegen, um eine normale Gasentladung erzeugen zu können. Die kontinuierliche Gasentladung im Druckbereich unterhalb von 10⁻² mbar kann nur mit Hilfe eines permanenten Magnetfelds aufrechterhalten werden.

Falls jedoch auf die Dauermagnete 10 und 11 oder den Stabmagneten 26 verzichtet wird, kann der Arbeitsdruck während des Aufbringens in einem Bereich oberhalb 5·10⁻³ mbar gehalten werden, so dass auf jeden Fall eine Ausgangsschicht mit der Schichtstruktur der Zone I erzeugt wird. Allerdings ist der Erosionsprozess in diesem Fall nicht lokal auf den Sputtermaterialblock 12 oder den Sputtermaterialmantel 29 beschränkt, sondern kann sich auch auf weitere Teile der Sputteranlage 1 und 22 erstrecken. Außerdem geht der Sputterprozess langsamer vor sich als bei der Verwendung einer Magnetron-Zerstäubungsanlage.

Die Oberfläche des Substrats 16 oder 24 kann vor Beginn des Sputtervorgangs einer Reinigung mittels Glimmentladung unterzogen werden. Falls eine selbsttragende Ausgangsschicht 21 oder 31 hergestellt werden soll, wird die Substratoberfläche nach der Reinigung oxidiert. Die Oxidschicht dient dann als Trennschicht beim Abheben der auf das Substrat 16 oder 24 aufgebrachten Ausgangsschicht 21 oder 31. Die Oxidschicht kann dünner 1 µm sein und braucht nur wenige Nanometer dick zu sein.

Abschließend sei noch darauf hingewiesen, dass Merkmale und Eigenschaften, die im Zusammenhang mit einem bestimmten Ausführungsbeispiel beschrieben worden sind, auch mit einem anderen Ausführungsbeispiel kombiniert werden können, außer wenn dies aus Gründen der Kompatibilität ausgeschlossen ist.

Schließlich wird noch darauf hingewiesen, dass in den Ansprüchen und in der Beschreibung der Singular den Plural einschließt, außer wenn sich aus dem Zusammenhang etwas anderes ergibt. Insbesondere wenn der unbestimmte Artikel verwendet wird, ist sowohl der Singular als auch der Plural gemeint.

## Patentansprüche

1. Verfahren zur Herstellung von Ausgangsmaterial für einen Technetium-Generator mit den Verfahrensschritten:
- Bereitstellen eines Substrats (16, 24), und
- Ausbilden einer Ausgangsschicht (21, 31) auf dem Substrat (16, 24) durch Aufsputtern von uranhaltigem Ausgangsmaterial aus der Gasphase auf das Substrat (16, 24),
**dadurch gekennzeichnet, dass** die Ausgangsschicht (21, 31) mit einer Schichtstruktur gemäß Zone I oder Zone T des Thornton-Diagramms des die Ausgangsschicht (21, 24) bildenden Ausgangsmaterials auf das Substrat (16, 24) aufgesputtert wird.

2. Verfahren nach Anspruch 1,
**dadurch gekennzeichnet, dass** das Substrat (16, 24) während des Aufbringens eine Temperatur T annimmt, für die T [K]/Tₛ [K] < 0,4 gilt, wobei Tₛ die Schmelztemperatur des Ausgangsmaterials ist.

3. Verfahren nach Anspruch 1,
**dadurch gekennzeichnet, dass** das Substrat (16, 24) während des Aufbringens eine Temperatur T annimmt, für die T [K]/Tₛ [K] < 0, 2 gilt, wobei Tₛ die Schmelztemperatur des Ausgangsmaterials ist.

4. Verfahren nach einem der Ansprüche 1 bis 3,
**dadurch gekennzeichnet, dass** das Substrat (16, 24) auf eine Temperatur unterhalb der Umgebungstemperatur gekühlt wird.

5. Verfahren nach einem der Ansprüche 1 bis 4,
**dadurch gekennzeichnet, dass** ein Material auf der Basis von Uran, eine metallische Uranlegierung oder eine Uranverbindung als Ausgangsmaterial verwendet wird.

6. Verfahren nach einem der Ansprüche 1 bis 5,
**dadurch gekennzeichnet, dass** das Ausgangsmaterial in einer Magnetron-Zerstäubungsanlage (1, 22) aufgebracht wird, die eine Sputterelektrode (6, 25) und eine Substratelektrode (13, 24) aufweist, zwischen denen ein elektrisches Feld vorhanden ist, und die ferner über eine Magnetanordnung (10, 11, 26) verfügt, die ein magnetisches Feld im Bereich der Sputterelektrode (6, 25) erzeugt.

7. Verfahren nach Anspruch 6,
**dadurch gekennzeichnet, dass** das Ausgangsmaterial in einer Magnetron-Zerstäubungsanlage (22) aufgebracht wird, bei der die Sputterelektrode (25) und die Substratelektrode (24) zylinderförmig ausgebildet sind, bei der sich die Sputterelektrode (25) im Inneren der Substratelektrode (24) befindet und bei der die Magnetanordnung einen im Inneren der Sputterelektrode (25) angeordneten Magneten (26) umfasst, dessen Magnetisierungsrichtung sich entlang der Längsachse (27) der Sputterelektrode (25) erstreckt.

8. Verfahren nach Anspruch 6 und 7,
**dadurch gekennzeichnet, dass** der Arbeitsdruck während des Aufbringens in einem Bereich zwischen 5·10⁻⁴ mbar und 5·10⁻² mbar gehalten wird.

9. Verfahren nach einem der Ansprüche 1 bis 8,
**dadurch gekennzeichnet, dass** der Druck während des Aufbringens von einem Druckbereich, in dem gemäß Thornton-Diagramm eine Ausgangsschicht mit der Schichtstruktur der Zone I gebildet wird, zu einem Arbeitsdruck abgesenkt wird, in dem gemäß Thornton-Diagramm eine Ausgangschicht mit der Schichtstruktur der Zone T gebildet wird.

10. Verfahren nach Anspruch 9,
**dadurch gekennzeichnet, dass** der Druck zu Beginn des Aufbringens im Bereich von 5·10⁻³ mbar bis 5·10⁻² mbar gehalten wird und anschließend auf den Arbeitsdruck abgesenkt wird.

11. Verfahren nach einem der Ansprüche 1 bis 5,
**dadurch gekennzeichnet, dass** eine Zerstäubungsanlage ohne Magnetanordnung verwendet wird und dass der Arbeitsdruck während des Aufbringens in einem Bereich oberhalb 5·10⁻³ mbar gehalten wird.

12. Verfahren nach einem der Ansprüche 1 bis 11,
**dadurch gekennzeichnet, dass** die Oberfläche des Substrats (16, 24) vor Beginn des Aufbringens einer Reinigung durch eine Glimmentladung unterzogen wird.

13. Verfahren nach einem der Ansprüche 1 bis 12,
**dadurch gekennzeichnet, dass** die Oberfläche des Substrats (16, 24) vor Beginn des Aufbringens mit einer Oxidschicht versehen wird.

14. Verfahren zur Herstellung eines Technetium-Generators
**dadurch gekennzeichnet, dass** ein mit einem Verfahren nach einem der Ansprüche 1 bis 13 hergestelltes Ausgangsmaterial mit Neutronen bestrahlt wird.

15. Ausgangsmaterial zur Herstellung eines Technetium-Generators mit einem Substrat (16, 24) und einer auf das Substrat (16, 24) aufgebrachten Ausgangsschicht (21, 24)
**dadurch gekennzeichnet, dass** die Ausgangsschicht (21, 24) eine Schichtstruktur gemäß Zone I oder Zone T des Thornton-Diagramms des die Ausgangschicht (21, 24) bildenden Ausgangsmaterials aufweist.

## Claims

1. A method for producing starting material for a technetium generator, comprising the following method steps:
- providing a substrate (16, 24), and
- forming a starting layer (21, 31) on the substrate (16, 24) by sputtering uranium-containing starting material from the gas phase onto the substrate (16, 24),
**characterised in that**
the starting layer (21, 31) is sputtered onto the substrate (16, 24) with a layer structure according to zone I or zone T of the Thornton diagram of the starting material forming the starting layer (21, 24).

2. The method according to claim 1,
**characterised in that**
the substrate (16, 24), during application, reaches a temperature for which T [K] /Tₛ [K] < 0.4, Tₛ being the melting temperature of the starting material.

3. The method according to claim 1,
**characterised in that**
the substrate (16, 24), during application, reaches a temperature for which T [K] /T_{S} [K] < 0.2, T_{S} being the melting temperature of the starting material.

4. The method according to any one of the claims 1 to 3,
**characterised in that**
the substrate (16, 24) is cooled to a temperature below the ambient temperature.

5. The method according to any one of the claims 1 to 4,
**characterised in that**
a material based on uranium, a metallic uranium alloy or a uranium compound is used as the starting material.

6. The method according to any one of the claims 1 to 5,
**characterised in that**
the starting material is applied in a magnetron sputtering system (1, 22) which has a sputter electrode (6, 25) and a substrate electrode (13, 24) between which an electric field is present, and which further has a magnet assembly (10, 11, 26) that generates a magnetic field in the region of the sputter electrode (6, 25).

7. The method according to claim 6,
**characterised in that**
the starting material is applied in a magnetron sputtering system (22) in which the sputter electrode (25) and the substrate electrode (24) are configured cylindrically, in which the sputter electrode (25) is situated in the interior of the substrate electrode (24), and in which the magnet assembly comprises a magnet (26) which is disposed in the interior of the sputter electrode (25) and whose direction of magnetization extends along the longitudinal axis (27) of the sputter electrode (25).

8. The method according to claim 6 and 7,
**characterised in that**
the operating pressure is maintained in a range of between 5·10⁻⁴ mbar and 5·10⁻² mbar during application.

9. The method according to any one of the claims 1 to 8,
**characterised in that**
during application, the pressure is lowered from a pressure range in which, according to the Thornton diagram, a starting layer with the layer structure of zone I is formed, to an operating pressure in which, according to the Thornton diagram, a starting layer with the layer structure of zone T is formed.

10. The method according to claim 9,
**characterised in that**
the pressure is maintained in the range of from 5·10⁻³ mbar to 5·10⁻² mbar at the start of the application, and is then lowered to the operating pressure.

11. The method according to any one of the claims 1 to 5,
**characterised in that**
a sputtering system without a magnet assembly is used and that the operating pressure is maintained in a range above 5·10⁻³ mbar during application.

12. The method according to any one of the claims 1 to 11,
**characterised in that**
the surface of the substrate (16, 24) is subjected to cleaning by means of a glow discharge prior to application.

13. The method according to any one of the claims 1 to 12,
**characterised in that**
the surface of the substrate (16, 24) is provided with an oxide layer prior to application.

14. A method for producing a technetium generator,
**characterised in that**
a starting material produced with a method according to any one of the claims 1 to 13 is irradiated with neutrons.

15. A starting material for producing a technetium generator with a substrate (16, 24) and a starting layer (21, 24) applied to the substrate (16, 24),
**characterised in that**
the starting layer (21, 24) has a layer structure according to zone I or zone T of the Thornton diagram of the starting material forming the starting layer (21, 24).

## Revendications

1. Procédé de fabrication de matériau de départ pour un générateur de technétium avec les étapes de procédé :
- préparation d'un substrat (16, 24), et
- réalisation d'une couche de départ (21, 31) sur le substrat (16, 24) par pulvérisation de matériau de départ contenant de l'uranium à partir de la phase gazeuse sur le substrat (16, 24),
**caractérisé en ce que**
la couche de départ (21, 31) est pulvérisée avec une structure en couches selon la zone I ou zone T du diagramme de Thornton du matériau de départ formant la couche de départ (21, 24) sur le substrat (16, 24).

2. Procédé selon la revendication 1,
**caractérisé en ce que**
le substrat (16, 24) adopte une température T pendant l'application pour laquelle T [K]/Tₛ [K] < 0,4 est valable, dans lequel Tₛ est la température de fusion du matériau de départ.

3. Procédé selon la revendication 1,
**caractérisé en ce que**
le substrat (16, 24) adopte une température T pendant l'application pour laquelle T [K]/Tₛ [K] < 0,2 est valable, dans lequel Tₛ est la température de fusion du matériau de départ.

4. Procédé selon une des revendications 1 à 3,
**caractérisé en ce que**
le substrat (16, 24) est refroidi à une température en dessous de la température ambiante.

5. Procédé selon une des revendications 1 à 4,
**caractérisé en ce que**
un matériau à base d'uranium, un alliage d'uranium métallique ou un composé d'uranium est utilisé comme matériau de départ.

6. Procédé selon une des revendications 1 à 5,
**caractérisé en ce que**
le matériau de départ est appliqué dans une installation d'atomisation à magnétron (1, 22) qui présente une électrode de pulvérisation (6, 25) et une électrode de substrat (13, 24) entre lesquelles un champ électrique est présent, et qui dispose en outre d'un agencement d'aimants (10, 11, 26) qui génère un champ magnétique dans la région de l'électrode de pulvérisation (6, 25).

7. Procédé selon la revendication 6,
**caractérisé en ce que**
le matériau de départ est appliqué dans une installation d'atomisation à magnétron (22) dans laquelle l'électrode de pulvérisation (25) et l'électrode de substrat (24) sont réalisées en forme de cylindre, dans laquelle l'électrode de pulvérisation (25) se trouve à l'intérieur de l'électrode de substrat (24) et dans laquelle l'agencement d'aimants comprend un aimant (26) disposé à l'intérieur de l'électrode de pulvérisation (25) dont la direction d'aimantation s'étend le long de l'axe longitudinal (27) de l'électrode de pulvérisation (25).

8. Procédé selon les revendications 6 et 7,
**caractérisé en ce que**
la pression de travail est maintenue dans une plage comprise entre 5·10⁻⁴ mbar et 5·10⁻² mbar pendant l'application.

9. Procédé selon une des revendications 1 à 8,
**caractérisé en ce que**
la pression pendant l'application est abaissée d'une plage de pression dans laquelle une couche de départ est formée avec la structure en couches de la zone I selon le diagramme de Thornton à une pression de travail dans laquelle une couche de départ est formée avec la structure en couches de la zone T selon le diagramme de Thornton.

10. Procédé selon la revendication 9,
**caractérisé en ce que**
la pression au début de l'application est maintenue dans la plage de 5·10⁻³ mbar à 5·10⁻² mbar, puis abaissée à la pression de travail.

11. Procédé selon une des revendications 1 à 5,
**caractérisé en ce que**
une installation d'atomisation sans agencement d'aimants est utilisée et que la pression de travail est maintenue dans une plage au-dessus de 5·10⁻³ mbar pendant l'application.

12. Procédé selon une des revendications 1 à 11,
**caractérisé en ce que**
la surface du substrat (16, 24) est soumise à un nettoyage par décharge lumineuse avant le début de l'application.

13. Procédé selon une des revendications 1 à 12,
**caractérisé en ce que**
la surface du substrat (16, 24) est pourvue d'une couche d'oxyde avant le début de l'application.

14. Procédé de fabrication d'un générateur de technétium,
**caractérisé en ce que**
un matériau de départ fabriqué avec un procédé selon une des revendications 1 à 13 est irradié de neutrons.

15. Matériau de départ pour la fabrication d'un générateur de technétium avec un substrat (16, 24) et une couche de départ (21, 24) appliquée sur le substrat (16, 24),
**caractérisé en ce que**
la couche de départ (21, 24) présente une structure en couches selon la zone I ou zone T du diagramme de Thornton du matériau de départ formant la couche de départ (21, 24).
